# FASCICULE DE BREVET EUROPEEN

(11) **EP 1 342 311 B1**
(45) Date de publication et mention de la délivrance du brevet: **16.06.2004**
(21) Numéro de dépôt: 01270946.5
(22) Date de dépôt: 12.12.2001
(51) Int. Cl.: H02N 13/00, H01L 21/00

(54) **DISPOSITIF DE PREHENSION ELECTROSTATIQUE D'UNE TRANCHE DE COMPOSANT ELECTRONIQUE**
ELEKTROSTATISCHEVORRICHTUNG ZUR GREIFEN EINES WAFERS
ELECTROSTATIC DEVICE FOR HOLDING AN ELECTRONIC COMPONENT WAFER

(30) Priorité: 12.12.2000 FR 0016154
(43) Date de publication de la demande: 10.09.2003
(73) Titulaire: Semco Engineering S.A., 34196 Montpellier cedex 5 (FR)
(72) Inventeur: FERRERES, David, F-34970 LATTES (FR)
(74) Mandataire: Ravina, Bernard
(86) Numéro de dépôt international: PCT/FR2001/003954
(87) Numéro de publication internationale: WO 2002/049200

(56) Documents cités:
- DE-A- 19 523 229
- DE-A- 19 715 083
- US-A- 5 258 047
- PATENT ABSTRACTS OF JAPAN vol. 014, no. 099 (E-0893), 22 février 1990 (1990-02-22) & JP 01 303079 A (ABISARE:KK), 6 décembre 1989 (1989-12-06)

## Description

L'invention est du domaine des techniques de manipulation de matériau en feuille, et plus particulièrement de composants électroniques micrométriques en tranche, tels que de silicium. L'invention a pour objet un dispositif de préhension d'un tel matériau, dit tranche.

On rappelle, dans le domaine des composants électroniques, l'utilisation d'éléments en feuille dits tranches, tels que de silicium. Le problème posé pour la préhension de telles tranches réside dans leur faible épaisseur. Plus particulièrement, le caractère mince de ces tranches, de l'ordre de quelques dizaines à plusieurs centaines de microns, rend leur préhension délicate au risque de les déformer, voire d'altérer les composants qu'elles supportent. De manière courante, ces tranches sont manipulées par l'intermédiaire de leur face passive, pour éviter une altération de leur autre face active, qui supporte des composants électroniques.

On connaît une technique de préhension des tranches, par aspiration. Par exemple, la tranche est plaquée par l'intermédiaire de sa face passive, contre une surface plane d'une ventouse d'une pipette qui véhicule une dépression. Cependant, l'évolution des techniques tend à amincir davantage les tranches, ce qui rend de plus en plus délicat leur préhension, voire rend impossible leur manipulation par aspiration à la manière susvisée. Par ailleurs, le fait de ne pourvoir prendre la tranche que par sa face passive, impose des techniques opératoires contraignantes de manipulation de la tranche.

Le document US-A-5 258 047 décrit un dispositif selon l'état de la technique le plus proche correspondant au préambule de la revendication 1.

Le but de la présente invention est de proposer un dispositif de préhension d'une tranche support de composants électroniques notamment, ou analogue, qui permette sa manipulation sans l'endommager ni la déformer, et sans risque d'altérer les composants électroniques qu'elle porte. Un autre but est de proposer un tel dispositif de préhension, qui permette la préhension d'une tranche, tant par sa face passive que par sa face active, en vue d'accroître les possibilités opératoires pour sa manipulation.

Le dispositif de la présente invention est du genre de dispositif selon la revendication 1 et comprenant un organe de préhension de la tranche, par soutien notamment, doté de moyens de maintien positif de cette dernière plaquée contre une surface globalement plane de l'organe de préhension.

La démarche inventive de la présente invention a consisté à proposer un dispositif de préhension électrostatique d'une tranche, comprenant un support rigide plan et mince, qui constitue l'organe de préhension susvisé. Au moins une électrode, qui constitue le moyen de maintien positif de la tranche, est rapportée sur l'une des faces du support plan, et est prévue pour être celle porteuse de la tranche.

Ce dispositif est un système de transport sans déformation d'une tranche de composants électroniques ou analogue. Le dispositif permet également ce transport par l'une ou l'autre des faces de la tranche passive ou active.

Ces dispositions sont telles que le support offre une surface de préhension de la tranche exempte de relief susceptible de l'altérer. Par ailleurs, le moyen de maintien positif de la tranche induit une puissance ajustable de préhension de cette dernière qui est répartie sur l'ensemble de la face correspondante du support. Il en résulte non seulement une répartition homogène des efforts de préhension sur la tranche, ce qui tend à la préserver de contraintes ponctuelles, mais aussi un meilleur maintien de cette dernière.

Grâce à ces dispositions, une tranche, même de très faible épaisseur telle que de l'ordre de la dizaine de microns, peut être prise sans risque d'être altérée ni déformée par la source de puissance des moyens de maintien positif. En outre, le dispositif de l'invention rend possible une préhension de la tranche par sa face active, nonobstant la présence de composants, sans risque d'altérer ni de détériorer ces derniers.

On comprendra que l'électrode, notamment en cuivre ou analogue, entendue comme délimitée par sa surface de superposition à la surface correspondante du support, est associée à des moyens distants d'alimentation en énergie électrique, auxquels elle est reliable par l'intermédiaire d'organes de connexion dont elle est pourvue.

Le support est quant à lui de préférence en matériaux rigide, isolant ou conducteur, de manière à offrir une rigidité idoine sans pour autant présenter une surépaisseur inopportune. Ce support thermostaté présente en outre la propriété d'ajuster et de contrôler la température.

L'électrode est avantageusement confinée entre deux feuilles d'un matériau isolant, Kapton (marque déposée) notamment ou tout autre matériau diélectrique, c'est à dire notamment à l'exception d'au moins une fenêtre d'accès à ses organes de connexion. Ces dispositions visent à protéger l'électrode, tant vis à vis de son contact avec le support, que vis à vis de l'environnement extérieur.

En vue notamment de la préhension d'une tranche conformée en disque, au moins l'électrode, sinon aussi et de préférence le support, est globalement conformée en «U » ou analogue. Chacune des branches de ce « U » correspond à une branche de l'électrode. La base du U est avantageusement prolongée par deux pattes de connexion affectées à une branche respective de l'électrode. On comprendra toutefois que la conformation de l'électrode, et l'agencement entre elles de ses branches, est notamment déterminée selon la conformation de la tranche à soutenir, de manière à répartir au mieux à la surface de cette dernière la puissance des moyens de maintien positif.

Il va de soi que toute autre forme géométrique du support et/ou de l'électrode est admissible sans sortir du cadre de l'invention.

Selon une forme préférée de réalisation, le dispositif de l'invention est complété par un organe pour la préhension du support, tel qu'un bras, en vue de sa manipulation. On notera que cette manipulation peut être indifféremment une manipulation manuelle ou une manipulation automatisée. Cet organe de préhension du support comporte des moyens de fixation du support, tels que par rivetage des organes de contrôle de la température, et des organes pour véhiculer l'énergie électrique ainsi que le contrôle de présence d'une tranche sur le support depuis la source distante jusqu'à l'électrode, qui sont raccordables aux organes de connexion de l'électrode, à travers la fenêtre susvisée par exemple.

La présente invention sera mieux comprise et des détails en relevant apparaîtront, à la description qui va en être faite d'une forme préférée de réalisation, en relation avec les figures de la planche annexée, dans laquelle :

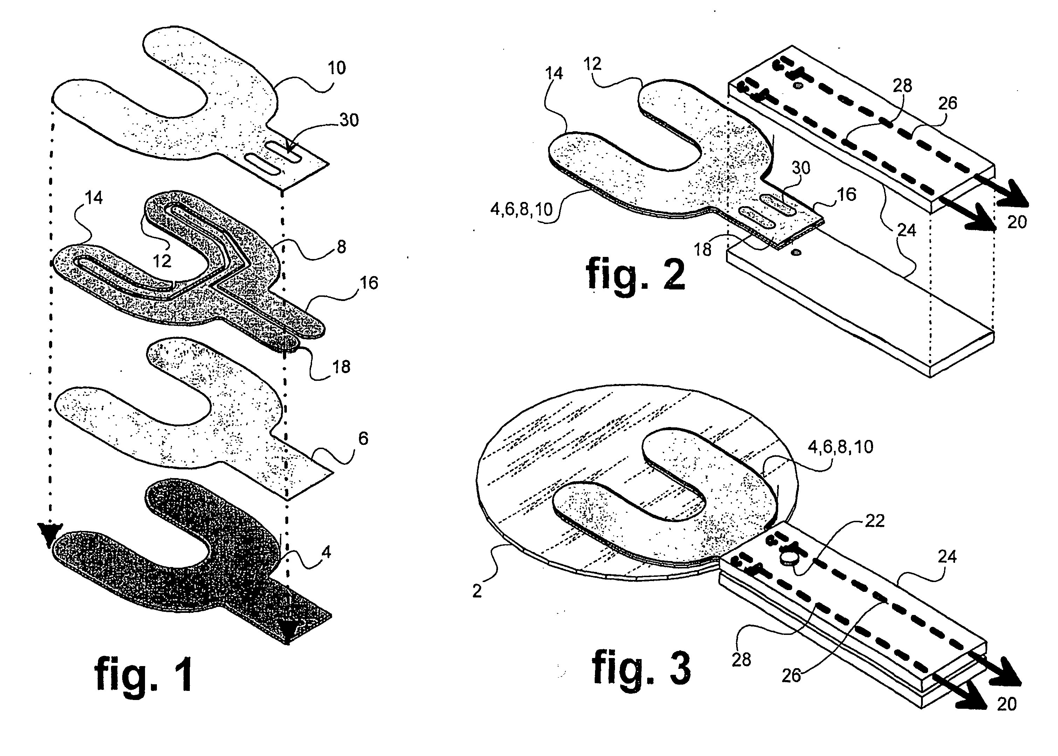

- la fig.1 est une vue en perspective éclatée d'un dispositif selon une forme préférée de réalisation de l'invention,
- les fig.2 et fig.3 sont des vues en perspective d'un dispositif représenté sur la fig.1 assemblé, qui est fixé à un bras de manipulation, ces vues étant respectivement des vues éclatée et assemblée de cette fixation.

Sur les figures, un dispositif de l'invention pour la préhension d'une tranche 2, est un dispositif stratifié comprenant successivement :
a) un support rigide plan 4, en inox notamment, ou en un matériau isolant céramique ou autre,
b) une première couche de matériau isolant 6, tel que Kapton ou tout autre matériau diélectrique,
c) une électrode 8, en cuivre ou analogue,
d) une deuxième couche de matériau isolant 10, tel que Kapton.

La première couche de Kapton est collée au support 4 ; l'électrode est pris entre les deux couches de Kapton 6-10 et la couche 10 de matériau isolant est, lors de la préhension, en contact avec la tranche à manipuler.

On remarquera la conformation particulière en U du support 4 et de l'électrode 8 qu'il porte. Chaque branche du U correspond à une branche respective 12 et 14 de l'électrode, prolongée par des organes de connexion 16 et 18 de l'électrode à une source distante 20 d'alimentation en électricité.

Le support 4 peut avoir toute forme géométrique adaptée pour obtenir une bonne préhension de la tranche.

L'électrode a une forme qui est adaptée à celle du support de même que les feuilles d'isolant..

Le support 6 est fixé par rivetage 22 à l'extrémité d'un bras de préhension 24. Ce bras 24 comporte des organes 26 et 28 de liaison électriques entre l'électrode 8 et la source d'alimentation distante 20. On remarquera que la couche 10 d'isolant supérieure recouvrant l'électrode 8 comporte des fenêtres d'accès, telles que 30, aux organes de connexion de cette dernière. Ces fenêtres 30 sont prévues pour permettre le contact entre les organes de connexion 16,18 de l'électrode 8, et les organes 26 et 28 de liaison électrique correspondant que comporte le bras 24.

On relèvera quelques caractéristiques idoines du dispositif de l'invention données à titre indicatif. Notamment, en ce qui concerne le support 4, l'inox utilisé est du type dit 316L, pour être le plus mince possible avec une rigidité suffisante. En outre, une planéité du support 4 de l'ordre de 0,01 % est souhaitable. L'ensemble composé par l'électrode 8 et les feuilles 6 et 10 de matériau isolant est de l'ordre de 110 µm, plus ou moins 10 µm. Les films isolants 6 et 10 de kapton garantissent une isolation électrique supérieure à 2000 Vdc de part et d'autre de l'électrode 8. Ils ont pour cela chacun une même épaisseur de l'ordre de 50 µm. L'électrode 8, quant à elle, est formée à partir d'une feuille de cuivre d'une épaisseur de l'ordre de 10 µm ou tout autre matériau électriquement conducteur.

## Revendications

1. Disposifif de préhension électrostatique d'une tranche (2) de composant électronique ou analogue, du genre de dispositif comprenant un organe de préhension de la tranche (2), doté de moyens de maintien positif de cette dernière plaquée contre une surface globalement plane de l'organe de préhension, cet organe de préhension comprenant un support (4) rigide plan et mince, et au moins une électrode (8) associée à des moyens distants (20) d'alimentation en énergie électrique, cette électrode étant rapportée sur l'une des faces du support plan (4), **caractérisé en ce que** le support est en métal difficilement altérable, l'électrode étant rapportée sur l'une des faces du support plan (4) en étant confinée dans sa quasi totalité entre deux feuilles (6,10) d'un matériau isolant, tandis que l'autre face du support (4), totalement plane, est prévue pour être celle porteuse de la tranche (2).

2. Dispositif selon la revendication 1 **caractérisé en ce que** l'électrode est reliée aux moyens distants (20) d'alimentation en énergie électrique par l'intermédiaire d'organes de connexion (16,18) dont elle est pourvue.

3. Dispositif selon l'une quelconque des revendications précédentes, **caractérisé en ce que** le support (4) est en inox

4. Dispositif selon la revendication 1, **caractérisé en ce que** le matériau isolant est le Kapton, dont chacune des feuilles (6, 10) a une épaisseur de l'ordre de 50 µm, pour une isolation électrique supérieure à 2000 Vdc de part et d'autre de l'électrode (8);

5. Dispositif selon l'une quelconque des revendications précédentes, caractère en ce que l'électrode (8) est formée à partir d'une feuille de cuivre d'une épaisseur de l'ordre de 10 µm.

6. Dispositif selon l'une quelconque des revendications précédentes, **caractérisé en ce qu'**au moins l'électrode (8), sinon aussi le support (4), est globalement conformée en «U », dont chacune des branches correspond à une branche (12,14) de l'électrode (8), et dont la base est prolongée par deux pattes de connexion (16,18) affectées à une branche respective (12, 14) de l'électrode (8).

7. Dispositif selon l'une quelconque des revendications précédentes. **caractérisé en ce qu'**il comprend en outre un organe (24) pour la préhension du support en vue de sa manipulation, qui comporte des moyens de fixation (22) du support (4), et des organes (26,28) raccordables aux organes de connexion (16,18) de l'électrode (8) pour véhiculer l'énergie électrique depuis une source distante (20) jusqu'à l'électrode (8).

## Patentansprüche

1. Elektrostatische Vorrichtung für das Greifen einer Scheibe (2) einer elektronischen Komponente oder von ähnlichem, von der Art einer Vorrichtung mit einem Organ für das Greifen der Scheibe (2), das mit Mitteln für einen positiven Halt der gegen eine global plane Fläche des Greiforgans gedrückten Scheibe versehen ist, wobei dieses Greiforgan einen starren, planen und dünnen Träger (4) umfasst sowie mindestens eine Elektrode (8), die mit entfernen Stromversorgungsmitteln (20) verbunden ist, wobei diese Elektrode auf einer der Flächen des planen Trägers (4) angebracht ist; der besagte Träger ist **dadurch gekennzeichnet, dass** er aus schwer veränderlichem Metall besteht, wobei die Elektrode auf einer der Flächen des planen Trägers (4) angebracht ist und beinahe vollständig zwischen zwei Blättern (6, 10) eines Isolationsmaterials eingeschlossen ist, während die andere Seite des Trägers (4), der volkommen plan ist, als tragende Seite der Scheibe (2) vorgesehen ist.

2. Vorrichtung gemäß Anspruch 1, die **dadurch gekennzeichnet ist, dass** die Elektrode über Anschlussorgane (16, 18), mit denen sie versehen ist, mit entfernten Stromversorgungsmitteln verbunden ist.

3. Vorrichtung gemäß einem beliebigen der obigen Ansprüche, die **dadurch gekennzeichnet ist, dass** der Träger (4) aus Edelstahl besteht.

4. Vorrichtung gemäß Anspruch 1, die **dadurch gekennzeichnet ist, dass** es sich bei dem Isolationsmaterial um Kapton handelt und jedes der Blätter (6, 10) eine Dicke von 50 µm besitzt, um eine elektrische Isolation auf beiden Seiten der Elektrode (8) von über 20000 Vdc zu erhalten.

5. Vorrichtung gemäß einem beliebigen der obigen Ansprüche, die **dadurch gekennzeichnet ist, dass** die Elektrode (8) aus einem Kupferblatt mit einer Stärke von 10 µm geformt ist.

6. Vorrichtung gemäß einem beliebigen der obigen Ansprüche, die **dadurch gekennzeichnet ist, dass** mindestens die Elektrode (8), wenn nicht auch der Träger (4) global eine U-Form hat oder haben, wobei jeder der Arme einem Arm (12, 14) der Elektrode (8) entspricht und dessen Basis um zwei Anschlusslaschen (16, 18) für jeweils einen Arm (12, 14) der Elektrode (8) verlängert ist.

7. Vorrichtung gemäß einem beliebigen der obigen Ansprüche, die **dadurch gekennzeichnet ist, dass** sie ferner ein Organ (24) für das Ergreifen des Trägers für dessen Handhabung umfasst, das Befestigungsmittel (22) des Trägers (4) und Organe (26, 28) besitzt, die an die Anschlussorgane (16, 18) der Elektrode (8) angeschlossen werden können, um die elektrische Energie von einer entfernten Stromquelle (29) bis zur Elektrode (8) zu leiten.

## Claims

1. Device for electrostatically gripping a wafer (2) of an electronic component or similar, device of the type including an element for gripping the wafer (2), equipped with means to positively hold the latter against an overall flat surface of the gripping element, such gripping element including a rigid, flat and thin support (4) and a minimum of one electrode (8) linked to remote means (20) of electrical power supply, the said electrode being positioned on one of the faces of the flat support (4), **characterized by** the fact that the support is in a metal that is not easily liable to deterioration, the electrode being added to one of the faces of the flat support (4) by being practically entirely enclosed between two sheets (6, 10) of an insulating material, while the other totally flat face of the support (4) is designed to be the one which bears the wafer (2).

2. Device in accordance with claim 1 **characterized by** the fact that the electrode is linked to remote means (20) of electrical power supply via connecting devices (16, 18) with which it is fitted.

3. Device in accordance with either of the previous claims, **characterized by** the fact that the support (4) is in stainless steel.

4. Device in accordance with claim 1 **characterized by** the fact that the insulating material is Kapton, each sheet of which (6, 10) is approximately 50µm thick, for an electrical insulation superior to 2000 Vdc either side of the electrode (8).

5. Device in accordance with any of the previous claims, **characterized by** the fact that the electrode (8) is made from a copper sheet approximately 10µm thick.

6. Device in accordance with any of the previous claims, **characterized by** the fact that at least the electrode (8), if not the support (4) as well, has an overall "U"-shape, each limb of which corresponds to a limb (12, 14) of the electrode (8) whose base is extended via two connection lugs (16, 18) assigned to a respective limb (12, 14) of the electrode (8).

7. Device in accordance with any of the previous claims, **characterized by** the fact that it additionally comprises an element (24) for gripping the support with a view to handling the same, including means of fastening (22) the support (4) and elements (26, 28) which may be coupled to the connecting devices (16, 18) of the electrode (8) so as to convey electrical power from a remote source (20) to the electrode (8).
